# EUROPÄISCHE PATENTANMELDUNG

(11) **EP 3 358 917 A1**
(43) Veröffentlichungstag der Anmeldung: **08.08.2018**
(21) Anmeldenummer: 17154961.1
(22) Anmeldetag: 07.02.2017
(51) Int. Cl.: H05K 1/02, H05K 3/34, H05K 3/40

(54) **LEITERPLATTE MIT EINER KÜHLFUNKTION**

(71) Anmelder: Siemens Aktiengesellschaft, 80333 München (DE)
(72) Erfinder: Seidel, Julian, 80339 München (DE)

(57) **Zusammenfassung**

Die Erfindung betrifft ein Verfahren zum Herstellen einer Leiterplatte (10) mit einer Kühlfunktion für ein in einer vorgegebenen Position auf der Leiterplatte (10) angeordnetes und an Leiterbahnen (14) der Leiterplatte (10) elektrisch angeschlossenes elektronisches Bauteil (16), mit:
- Herstellen der Leiterplatte (10), indem auf einem Leiterplattenmaterial (18) die Leiterbahnen (14) zumindest an einer Oberfläche (20) des Leiterplattenmaterials (18) aufgebracht werden, wobei die Leiterbahnen (14) zumindest elektrische Kontaktflächen (12) zum elektrischen Kontaktieren des wenigstens einen elektronischen Bauteils (16) bereitstellen,
- Einbringen einer Durchgangsöffnung (22) in die Leiterplatte (10) im Bereich der vorgegebenen Position, und
- Hindurchführen eines Wärmeleitkörpers (24) durch die Durchgangsöffnung (22) zur Kühlung des elektronischen Bauteils (16).

## Beschreibung

Die Erfindung betrifft ein Verfahren zum Herstellen einer Leiterplatte mit einer Kühlfunktion für ein in einer vorgegebenen Position auf der Leiterplatte angeordnetes und an Leiterbahnen der Leiterplatte elektrisch angeschlossenes elektronisches Bauteil, mit Herstellen der Leiterplatte, indem auf einem Leiterplattenmaterial die Leiterbahnen zumindest an einer Oberfläche des Leiterplattenmaterials aufgebracht werden, wobei die Leiterbahnen zumindest elektrische Kontaktflächen zum elektrischen Kontaktieren des wenigstens einen elektronischen Bauteils bereitstellen, und Einbringen einer Durchgangsöffnung in die Leiterplatte im Bereich der vorgegebenen Position. Weiterhin betrifft die Erfindung eine Leiterplatte mit einer Kühlfunktion für wenigstens ein in einer vorgegebenen Position auf der Leiterplatte anordbares und an Leiterbahnen der Leiterplatte elektrisch anschließbares elektronisches Bauteil, mit einem Leiterplattenmaterial, den Leiterbahnen, die zumindest an einer Oberfläche des Leiterplattenmaterials angeordnet sind und die zumindest elektrische Kontaktflächen zum elektrischen Kontaktieren des wenigstens einen elektronischen Bauteils aufweisen, und einer in die Leiterplatte im Bereich der vorgegebenen Position eingebrachte Durchgangsöffnung.

Elektronische Schaltungen werden häufig dadurch realisiert, dass elektronische Bauteile, mit denen die elektronische Schaltung realisiert werden soll, auf einer entsprechenden Leiterplatte als Trägereinheit angeordnet werden. Die Leiterplatte stellt Leiterbahnen bereit, die Kontaktflächen umfassen, mit denen Kontaktelemente der elektronischen Bauteile elektrisch kontaktiert werden können, sodass eine elektrische Verbindung zwischen den elektronischen Bauteilen und den Leiterbahnen in vorgegebener Weise hergestellt werden kann, sodass die mit den elektronischen Bauteilen bestückte Leiterplatte die gewünschte Funktionalität bereitzustellen vermag.

Die elektronischen Bauteile werden heutzutage üblicherweise als SMD (Surface Mounted Device)-Bauteile, bedrahtete elektronische Bauteile und/oder dergleichen bereitgestellt. Die Leiterplatte ist diesbezüglich entsprechend angepasst und stellt geeignete Kontaktflächen bereit. Bei bedrahteten elektronischen Bauteile sind zusätzlich entsprechende Bohrungen in dem Leiterplattenmaterial der Leiterplatte vorgesehen, in das entsprechende Drahtenden der bedrahteten elektronischen Bauteile vor einem Lötvorgang eingesteckt werden. Die bestückte Leiterplatte wird sodann dem Lötvorgang unterzogen, was zum Beispiel ein Löten in einem Lötbad, ein Durchführen durch einen Reflow-Lötofen und/oder dergleichen umfassen kann. Ein elektronisches Bauteil kann zum Beispiel ein passives elektronisches Bauteil wie ein elektrischer Widerstand, ein elektrischer Kondensator, eine elektrische Induktivität und/oder dergleichen sein. Das elektronische Bauteil kann aber auch ein aktives elektronisches Bauteil, insbesondere ein Halbleiterbauelement oder dergleichen, sein wie zum Beispiel eine Diode, ein Transistor, eine integrierte Schaltung (IC) und/oder dergleichen.

Je nach Funktionalität, die mittels des elektronischen Bauteils bereitzustellen ist, fällt im bestimmungsgemäßen Betrieb mehr oder weniger Wärme als Verlustleistung an. Insbesondere bei Leistungshalbleitern sind häufig geeignete Kühlungsmaßnahmen für den bestimmungsgemäßen Betrieb vorzusehen. Eine normale Kühlung durch die Anordnung auf der Leiterplatte reicht dann nicht immer aus. Sind die Möglichkeiten einer Kühlung auf der Leiterplatte begrenzt, kann dann ein größeres leistungsfähigeres elektronisches Bauteil bestückt werden, um die bestimmungsgemäße Funktionalität realisieren zu können.

Mit der zunehmenden Anwendung von elektronisch verfügbaren Funktionen steigt auch das Bedürfnis, die Integration, insbesondere eine Packungsdichte, zu erhöhen. Darüber hinaus ist eine hohe Packungsdichte vorteilhaft für die elektromagnetische Verträglichkeit, sodass für bestimmte Funktionen eine hohe Integrationsdichte gewünscht ist.

Bei hoher Integration tritt jedoch insbesondere bei Halbleitern als elektronische Bauteile, besonders bei Leistungshalbleitern, das Problem der Kühlung in den Vordergrund. Nicht nur aber besonders bei Nutzung der SMD-Technologie ist häufig eine Kühlfunktion, die durch Aufbringen des elektronischen Bauteils auf der Leiterplatte bereitgestellt wird, begrenzt. Insbesondere betrifft dies Leiterplattenumrichter, die heutzutage aus Kostengründen immer häufiger eingesetzt werden.

Dabei erweist es sich insbesondere als Problem, dass die aufgelöteten Leistungshalbleiter durch eine sehr schlechte Wärmeleitfähigkeit des Leiterplattenmaterials, welches üblicherweise FR4 ist, nur unzureichend gekühlt werden können und damit nur ein Bruchteil der Leistungsfähigkeit des Leistungshalbleiters zur Verfügung steht. Es wird also beispielsweise eine Überdimensionierung vorgesehen, die aus rein elektrischer Sicht nicht erforderlich wäre.

Viele Leistungshalbleiter weisen Gehäuse auf, wie zum Beispiel D2PACK, TO, PQFN, SO8 und/oder dergleichen, die auf einer Gehäuseunterseite eine thermische Kontaktfläche als Kühlfläche zum Abführen von Wärme aufweisen. Über diese Kontaktfläche wird der entsprechende Leistungshalbleiter im Wesentlichen gekühlt. Wird diese Kontaktfläche auf einer Oberfläche des Leiterplattenmaterials aufgebracht, kann eine Kühlung nur im Wesentlichen nur sehr begrenzt wirksam realisiert werden.

Der Erfindung liegt die Aufgabe zugrunde, eine verbesserte Kühlung für ein elektronisches Bauteil, insbesondere eines Leistungshalbleiters, bereitzustellen, welches an einer Leiterplatte angeordnet ist.

Als Lösung schlägt die Erfindung ein Verfahren sowie eine Leiterplatte gemäß den unabhängigen Ansprüchen vor.

Weitere vorteilhafte Ausgestaltungen ergeben sich anhand von Merkmalen der abhängigen Ansprüche.

Bezüglich eines gattungsgemäßen Verfahrens wird insbesondere vorgeschlagen, dass ein Wärmeleitkörper durch die Durchgangsöffnung zur Kühlung des elektronischen Bauteils hindurchgeführt wird.

Leiterplattenseitig wird für eine gattungsgemäße Leiterplatte insbesondere vorgeschlagen, dass die Leiterplatte einen Wärmeleitkörper aufweist, der durch die Durchgangsöffnung zur Kühlung des elektronischen Bauteils hindurchgeführt ist.

Die Erfindung basiert auf dem Gedanken, dass durch Anordnen des Wärmeleitkörpers in der Durchgangsöffnung der Leiterplatte an einer Stelle, an der das elektronische Bauteil Wärme abzugeben vermag, die Wärmeabführung von dem elektronischen Bauteil erheblich verbessert werden kann. Dadurch kann das elektronische Bauteil hinsichtlich seiner elektrischen Leistungsfähigkeit besser ausgenutzt werden.

Das elektronische Bauteil ist vorzugsweise ein aktives elektronisches Bauteil, vorzugsweise ein Halbleiterbauteil, insbesondere ein Leistungshalbleiter. Es kann darüber hinaus jedoch auch ein passives elektronisches Bauelement, beispielsweise ein elektrischer Widerstand oder dergleichen, sein.

Das Verfahren stellt somit eine Kühlfunktion für wenigstens ein in der vorgegebenen Position auf der Leiterplatte angeordnetes und an den Leiterbahnen der Leiterplatte elektrisch angeschlossenes elektronisches Bauteil bereit. Es kann ferner die folgenden Schritte oder einzelne oder mehrere der folgenden Schritte umfassen: Herstellen der Leiterplatte, indem auf einem Leiterplattenmaterial die Leiterbahnen aufgebracht werden, wobei zumindest an der vorgegebenen Position elektrische Kontaktflächen zum elektrischen Kontaktieren von Kontaktelementen des wenigstens einen elektronischen Bauteils ausgebildet werden, Bestücken der Leiterplatte zumindest mit dem wenigstens einen elektronischen Bauteil, sodass die elektrischen Kontaktelemente des wenigstens einen elektronischen Bauteils an den Kontaktflächen angeordnet werden, und Durchführen eines Lötverfahrens zum elektrischen Verbinden der elektrischen Kontaktelemente mit den Kontaktflächen.

Ferner kann das Verfahren der Erfindung ergänzend die Schritte aufweisen: Bereitstellen eines Wärmeleitkörpers, dessen Abmessungen an einen Öffnungsquerschnitt der Durchgangsöffnung angepasst sind, und Einpressen des Wärmeleitkörpers in die Durchgangsöffnung und/oder Einkleben des Wärmeleitkörpers in der Durchgangsöffnung, sodass der Wärmeleitkörper das elektronische Bauteil in bestücktem Zustand kontaktiert, wobei die Abmessungen des Wärmeleitkörpers ergänzend derart gewählt werden, dass durch den Wärmeleitkörper auf einer einer Bestückungsseite des wenigstens einen elektronischen Bauteils gegenüberliegenden Leiterplattenseite eine Wärmesenke kontaktiert wird.

Die Leiterplatte Erfindung kann ferner eine Kühlfunktion für wenigstens ein in einer vorgegebenen Position auf der Leiterplatte anordbares und an Leiterbahnen der Leiterplatte elektrisch anschließbares elektronisches Bauteil bereitstellen, wobei die Leiterplatte ergänzend zumindest eines oder mehrere der folgenden Merkmale umfassen kann: ein Leiterplattenmaterial, die Leiterbahnen, die zumindest an einer Oberfläche des Leiterplattenmaterials angeordnet sind und die zumindest an der vorgegebenen Position elektrische Kontaktflächen zum elektrischen Kontaktieren von an den Kontaktflächen anordbaren elektrischen Kontaktelementen des wenigstens einen elektronischen Bauteils aufweisen, und eine in die Leiterplatte im Bereich der vorgegebenen Position eingebrachte Durchgangsöffnung.

Ferner kann die Leiterplatte einen Wärmeleitkörper aufweisen, dessen Abmessungen an einem Öffnungsquerschnitt der Durchgangsöffnung derart angepasst gewählt sind, dass der Wärmeleitkörper in der Durchgangsöffnung mittels einer Presspassung und/oder mittels eines Klebstoffs gehalten ist, wobei der Wärmeleitkörper in der Durchgangsöffnung derart positioniert ist, dass der Wärmeleitkörper das elektronische Bauteil im bestückten Zustand kontaktiert, wobei die Abmessungen des Wärmeleitkörpers ergänzend derart gewählt sind, dass der Wärmeleitkörper auf einer einer Bestückungsseite des wenigstens einen elektronischen Bauteils gegenüberliegenden Leiterplattenseite eine Wärmesenke kontaktiert.

Vorzugsweise ist der Wärmeleitkörper ausgebildet, eine Kontaktoberfläche bereitzustellen, die das elektronische Bauteil, insbesondere eine Kühlfläche des elektronischen Bauteils, zu kontaktieren vermag. Dabei weist der Wärmeleitkörper vorzugsweise eine Höhe auf, die zumindest einer Erstreckung der Durchgangsöffnung in einer axialen Richtung im Wesentlichen entspricht. Die Durchgangsöffnung und der Wärmeleitkörper können in Bezug auf einen Querschnitt im Wesentlichen eine angepasste Kontur aufweisen. Die Kontur kann eine Kreisform, eine Ellipsenform, eine eckige Form, insbesondere eine Rechteckform, Kombinationen hiervon oder dergleichen aufweisen. Vorteilhaft erweist sich zum Beispiel die Kreisform, weil für das Anordnen des Wärmeleitkörpers in der Durchgangsöffnung eine Orientierung in Umfangsrichtung nicht berücksichtigt zu werden braucht. Besonders vorteilhaft ist der Querschnitt jedoch im Wesentlichen rechteckig ausgebildet, vorzugsweise mit abgerundeten Ecken, weil Leistungshalbleiter in der Regel eine rechteckige Kühlfläche, auch Thermal Pad genannt, aufweisen. Der Querschnitt ist somit vorzugweise an eine Kühlfläche des zu kontaktierenden Leistungshalbleiters angepasst ausgebildet.

Der Wärmeleitkörper kann vorzugsweise durch eine Presspassung oder auch mittels eines Klebers in der Durchgangsöffnung der Leiterplatte fixiert sein. Natürlich kann auch eine Kombination hiervon vorgesehen sein.

Vorzugsweise wird der Wärmeleitkörper mit der Leiterplatte verbunden, bevor eine Bestückung der Leiterplatte mit dem wenigstens einen elektronischen Bauteil erfolgt. Bei Bedarf kann jedoch auch vorgesehen sein, dass der Wärmeleitkörper zugleich mit der Bestückung der Bauteile an der Leiterplatte angeordnet wird oder auch danach.

Der Wärmeleitkörper weist vorzugsweise eine höhere Wärmeleitfähigkeit als die Leiterplatte beziehungsweise das Leiterplattenmaterial auf. Der Wärmeleitkörper kann beispielsweise ein einstückiger Körper sein, der aus einem Material gebildet ist, welches eine hohe Wärmeleitfähigkeit aufweist. Er kann darüber hinaus aber auch aus unterschiedlichen Materialien gebildet sein, die es erlauben, eine entsprechend gute Wärmeleitfähigkeit bereitstellen zu können. Vorzugsweise ist der Wärmeleitkörper aus einem Metall gebildet. Dem Grunde nach kann er jedoch auch aus einer geeigneten Keramik oder dergleichen gebildet sein, die eine entsprechend gute Wärmeleitfähigkeit bereitzustellen vermag.

Vorteilhaft enthält der Wärmeleitkörper überwiegend Kupfer, Silber, Aluminium oder eine Legierung mit wenigstens einem der vorgenannten Stoffe. Diese Stoffe haben sich als besonders günstig für eine Wärmeleitung erwiesen. Darüber hinaus sind sie wirtschaftlich vergleichsweise günstig verfügbar und können mit bekannten Herstellungsverfahren auf günstige Weise für den Zweck der Erfindung hergestellt werden.

Eine Weiterbildung der Erfindung sieht vor, dass vor dem Schritt des Bestückens am Wärmeleitkörper ein Lot angeordnet wird. Dadurch ist es möglich, eine thermische gut leitfähige Verbindung zu dem elektronischen Bauteil herzustellen, insbesondere wenn dieses selbst eine lötbare Kühlfläche bereitstellt, wie dies bei vielen Gehäusen für Halbleiter, insbesondere Leistungshalbleiter, der Fall ist.

Eine vorteilhafte Weiterbildung sieht vor, dass der Wärmeleitkörper als Wärmesenke Luft und/oder eine Heat-Pipe kontaktiert. Dadurch ist es möglich, eine gute Kühlwirkung mittels des Wärmeleitkörpers zu erreichen. Dadurch, dass der Wärmeleitkörper zugleich an die Wärmesenke angekoppelt ist, kann eine gute Wärmeabführung vom elektronischen Bauteil über den Wärmeleitkörper zur Wärmesenke hin erreicht werden. Die Wärmesenke kann im einfachsten Falle Luft sein, insbesondere eine Luftströmung, die mittels eines Gebläses bereitgestellt wird. Darüber hinaus kann natürlich auch vorgesehen sein, dass der Wärmeleitkörper die Heat-Pipe kontaktiert, mit der eine große Wärmemenge abgeführt werden kann. Insgesamt kann die Wirkung des Wärmeleitkörpers dadurch deutlich verbessert werden.

Vorzugsweise kann der Wärmeleitkörper gemeinsam mit dem wenigstens einen elektronischen Bauteil bestückt werden. Dadurch kann auf einfache Weise die gewünschte Bestückung der Leiterplatte mit dem elektronischen Bauteil und zugleich dem Wärmeleitkörper erreicht werden. Dadurch können separate Bestückungsschritte reduziert werden. Gegebenenfalls kann hierfür vorgesehen sein, dass der Wärmeleitkörper mittels eines geeigneten Montagemittels, beispielsweise eines Roboterarms und/oder dergleichen, in der Durchgangsöffnung angeordnet wird, während zugleich das elektronische Bauteil bestückt wird, welches den Wärmeleitkörper kontaktiert.

Um eine gute Ankopplung an Luft als Wärmesenke erreichen zu können, wird ferner vorgeschlagen, dass der Wärmeleitkörper insbesondere einstückig mit dem Wärmeleitkörper ausgebildete Kühlrippen aufweist. Durch die Kühlrippen kann eine Oberfläche des Wärmeleitkörpers in Bezug auf die Wärmesenke vergrößert werden, sodass ein guter Wärmeübergang erreicht werden kann. Dies betrifft insbesondere Wärmesenken fluidischer Natur wie zum Beispiel Luft, Wasser und/oder dergleichen.

Weiterhin wird vorgeschlagen, dass der Wärmeleitkörper mittels eines additiven Herstellverfahrens unmittelbar in der Durchgangsöffnung hergestellt wird. Hierdurch ist es möglich, auf einfache Weise auch eine sehr komplexe Struktur für in Wärmeleitkörper zu realisieren, insbesondere wenn sich ein solcher Wärmeleitkörper aufgrund einer besonderen Struktur ansonsten nicht durch die Durchgangsöffnung hindurchführen lassen würde. Als additives Herstellverfahren können unterschiedliche Verfahren zum Einsatz kommen, beispielsweise ein Sinter- oder Pulverdruckverfahren, ein Drucken mit extrudierten Baumaterialien, eine Stereolithographie und/oder dergleichen. Insbesondere eignen sich als additives Herstellungsverfahren ein 3D-Drucken mit Pulver (3DB), selektives Lasersintern (SLS), selektives Laserschmelzen (SLM) oder dergleichen. Diese additiven Herstellverfahren eignen sich besonders für die Herstellung des Wärmeleitkörpers. Bezüglich der Herstellverfahren wird ergänzend auf 3D-Drucken von Petra Fastermann verwiesen, Verlag Springer Viehweg, 2014.

Es kann ferner vorgesehen sein, dass der Wärmeleitkörper zumindest in einem Verbindungsbereich mit der Durchgangsöffnung eine elektrische Isolation aufweist. Diese Ausgestaltung eignet sich insbesondere für den Fall, dass der Wärmeleitkörper selbst elektrisch leitfähig ist und die Leiterplatte im Bereich der Durchgangsöffnung elektrisch leitfähige Bereiche, insbesondere Leiterbahnen, aufweist. Durch die elektrische Isolation des Wärmeleitkörpers im Bereich der Durchgangsöffnung kann erreicht werden, dass hierdurch keine unerwünschten elektrischen Wechselwirkungen auftreten. Die elektrische Isolation kann durch eine entsprechende Beschichtung vorgesehen sein, die vor dem Anordnen des Wärmeleitkörpers in der Durchgangsöffnung auf dem Wärmeleitkörper, insbesondere zumindest seinem Außenumfang, der im Bereich der Durchgangsöffnung angeordnet wird, aufgebracht wird. Die elektrische Isolation kann jedoch auch zumindest teilweise durch eine Oxidschicht bereitgestellt werden, die zum Beispiel durch eine Oxidation einer Oberfläche des Wärmeleitkörpers bereitgestellt werden kann.

Ferner wird vorgeschlagen, dass der Wärmeleitkörper auf der der Bestückungsseite des wenigstens einen elektronischen Bauteils gegenüberliegenden Leiterplattenseite einen Anschlag aufweist. Durch den Anschlag kann auf einfache Weise eine zuverlässige und vorschriftsmäßige Montage des Wärmeleitkörpers an der Leiterplatte erreicht werden. So kann durch den Anschlag erreicht werden, dass der Wärmeleitkörper in einer vorgegebenen Höhenposition in Bezug auf die Leiterplatte positioniert ist, sodass eine zuverlässige und günstige Kontaktierung des elektronischen Bauteils erreicht werden kann. Beispielsweise kann vorgesehen sein, dass der Wärmeleitkörper über eine Oberfläche der Leiterplatte, auf der das elektronische Bauteil bestückt werden soll, nämlich einer Bestückungsseite, hinausragt, wenn das bestückte elektronische Bauteil, insbesondere dessen Kühlfläche, die Leiterplatte selbst nicht unmittelbar kontaktiert, beispielsweise weil sie zu dieser beabstandet ist oder dergleichen. Auch in diesem Fall kann das elektronische Bauteil durch geeignete Ausgestaltung des Wärmeleitkörpers, insbesondere in Bezug auf seine Höhe, in axialer Richtung ein zuverlässiges Kontaktieren des elektronischen Bauteils, insbesondere seiner Kühlfläche, ermöglichen. Mit dem Wärmeleitkörper kann in diesem Fall also auch auf Besonderheiten des elektronischen Bauteils, insbesondere seines Gehäuses, eingegangen werden.

Eine Weiterbildung der Erfindung sieht vor, dass der Wärmeleitkörper mit wenigstens einer der elektrischen Leiterbahnen elektrisch verbunden ist. Dadurch ist der Wärmeleitkörper mit einem vorgebbaren elektrischen Potential beaufschlagbar, insbesondere, wenn er elektrisch leitfähig ist. Der Wärmeleitkörper kann darüber hinaus selbst als elektrischer Anschluss für das elektronische Bauteil bereitstehen, welches er gleichzeitig zum Zwecke der Kühlung kontaktieren soll. Über die Kontaktmöglichkeit zum Kühlen kann zugleich auch ein elektrischer Kontakt bereitgestellt werden. Dies kann für eine Vielzahl von im Stand der Technik üblichen Gehäusen für Halbleiter, insbesondere für Leistungshalbleiter, genutzt werden, deren Kühlflächen üblicherweise zugleich auch ein elektrisches Potential des entsprechenden Halbleiters bereitstellen. Dadurch kann ein elektrischer Anschluss einfacher und zuverlässiger ausgestaltet werden.

Weitere Vorteile und Merkmale sind der folgenden Beschreibung von Ausführungsbeispielen anhand der beigefügten Figuren zu entnehmen. In den Figuren bezeichnen gleiche Bezugszeichen gleiche Merkmale und Funktionen.

Es zeigen:
- FIG 1: in einer schematischen Schnittansicht eine mit einem Leistungshalbleiter bestückte Leiterplatte und einen Wärmeleitkörper gemäß der Erfindung,
- FIG 2: eine Darstellung wie FIG 1, bei der der Wärmeleitkörper Kühlrippen aufweist,
- FIG 3: eine Darstellung wie FIG 1, bei der der Wärmeleitkörper thermisch an einer Heat-Pipe angekoppelt ist, und
- FIG 4: eine Darstellung wie FIG 3, bei der anstelle der Heat-Pipe ein Wasserkühler vorgesehen ist.

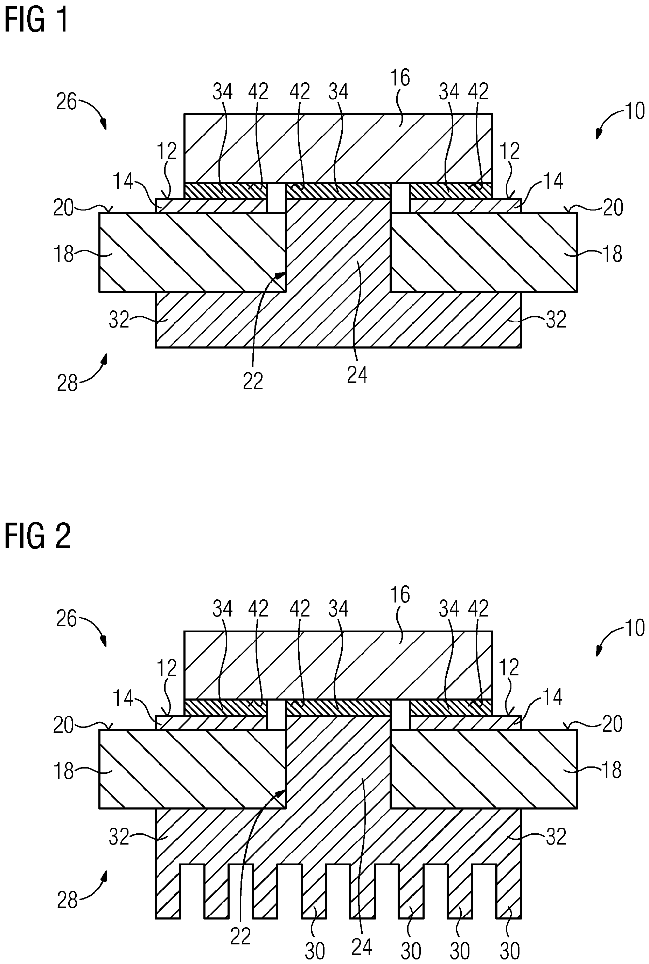

FIG 1 zeigt in einer schematischen Schnittansicht eine Leiterplatte 10 mit einer Kühlfunktion für einen Leistungshalbleiter 16 als elektronisches Bauteil, der in einer vorgegebenen Position auf der Leiterplatte 10 angeordnet und an Leiterbahnen 14 der Leiterplatte 10 elektrisch angeschlossen ist.

Die Leiterplatte 10 besteht aus einem Leiterplattenmaterial 18, welches vorliegend durch FR-4 gebildet ist. Es kann an dieser Stelle jedoch auch ein nahezu beliebiges anderes Leiterplattenmaterial eingesetzt sein, beispielsweise Hartpapier oder dergleichen.

Auf einer Oberfläche 20 des Leiterplattenmaterials an einer Bestückungsseite 26 für den Leistungshalbleiter 16 sind Leiterbahnen 14 aufgebracht, die Kontaktflächen 12 zum elektrischen Kontaktieren von an den Kontaktflächen 12 angeordneten elektrischen Kontaktelementen 42 des Leitungshalbleiters 16 aufweisen.

Aus FIG 1 ist ersichtlich, dass die Kontaktelemente 42 des Leitungshalbleiters 16 mittels Lot 34 mit den Kontaktflächen 12 elektrisch leitend verbunden sind. Zugleich wird der Leistungshalbleiter 16 hierdurch auch mechanisch festgelegt.

Aus FIG 1 ist ferner ersichtlich, dass das Leiterplattenmaterial 18 eine Durchgangsöffnung 22 aufweist. In der Durchgangsöffnung 22 ist ein Wärmeleitkörper 24 hindurchgeführt, der der Kühlung des Leistungshalbleiters 16 dient. Der Wärmeleitkörper 24 ist vorliegend aus Kupfer gebildet. Der Wärmeleitkörper 24 ist in der Durchgangsöffnung 22 derart positioniert, dass der Wärmeleitkörper 24 den Leistungshalbleiter 16 im bestückten Zustand kontaktiert, indem eine nicht bezeichnete Kühlfläche des Leistungshalbleiters 16 kontaktiert wird.

Die Abmessungen des Wärmeleitkörpers 24 sind derart gewählt, dass der Wärmeleitkörper 24 auf der der Bestückungsseite 26 des Leistungshalbleiters 16 gegenüberliegenden Leiterplattenseite 28 eine Wärmesenke kontaktiert. Vorliegend ist vorgesehen, dass der Wärmeleitkörper 24 Umgebungsluft als Wärmesenke kontaktiert.

Der Wärmeleitkörper 24 weist auf der der Bestückungsseite 26 des Leistungshalbleiters 16 gegenüberliegenden Leiterplattenseite 28 einen Anschlag 32 auf. Dadurch ist er hinsichtlich seine Positionierung festgelegt, sodass er auf einfache Weise auf der Leiterplatte 10 bestückt werden kann.

Aus FIG 1 ist weiterhin ersichtlich, dass der Wärmeleitkörper 24 auf der Bestückungsseite 26 etwa vergleichbar wie die Leiterbahnen 14 aus dem Leiterplattenmaterial 18 herausragt. Zugleich ist auch hier Lot 34 aufgebracht, sodass der Wärmeleitkörper 24 mit dem Leistungshalbleiter 16 verlötet ist. Dadurch kann ein sehr guter thermischer Kontakt bereitgestellt werden, sodass Wärme aus dem Leistungshalbleiter 16 gut abgeführt werden kann.

Die Anbindung des Wärmeleitkörpers 24 mittels dem Lot 34 kann ergänzend auch dazu genutzt werden, einen elektrischen Anschluss eines elektrischen Potentials an den Leistungshalbleiter 16 bereitzustellen. Zu diesem Zweck kann der Wärmeleitkörper 24 eine Leiterbahn kontaktieren, beispielsweise auf der der Bestückungsseite 26 gegenüberliegenden Leiterplattenseite 28. Dies ist in FIG 1 jedoch nicht dargestellt und optional realisierbar.

Sollte es erforderlich sein, kann der Wärmeleitkörper 24 im Bereich der Durchgangsöffnung 22 auch mit einer elektrischen Isolation versehen werden, beispielsweise, um Kriech- und Luftstrecken einhalten zu können, die beispielsweise aufgrund einer Normung oder dergleichen vorgesehen sein können.

In der vorliegenden Ausgestaltung ist vorgesehen, dass der Wärmeleitkörper 24 einstückig ausgebildet ist. Je nach Bedarf kann er aber auch zwei- oder mehrteilig ausgebildet sein, um beispielsweise besondere konstruktive Anforderungen erfüllen zu können.

Die Leiterplatte 10 gemäß FIG 1 stellt eine Kühlfunktion für den Leistungshalbleiter 16 bereit. Sie wird hergestellt, indem auf dem Leiterplattenmaterial 18 die Leiterbahnen 14 vorliegend an der Oberfläche 20 des Leiterplattenmaterials 18 aufgebracht werden. Die Leiterbahnen 14 stellen die elektrischen Kontaktflächen 12 zum elektrischen Kontaktieren des Leistungshalbleiters 16 bereit. In die Leiterplatte 10 beziehungsweise in das Leiterplattenmaterial 18 wird dann im Bereich der vorgegebenen Position die Durchgangsöffnung 22 eingebracht. Schließlich wird der Wärmeleitkörper 24 durch die Durchgangsöffnung 22 zur Kühlung des elektronischen Bauteils 16 hindurchgeführt.

Sodann wird die Leiterplatte 10 mit dem Leistungshalbleiter 16 bestückt, sodass dessen elektrische Kontaktelemente 42 an den Kontaktflächen 12 angeordnet werden. Schließlich wird ein Lötverfahren zum elektrischen Verbinden der elektrischen Kontaktelemente 42 mit den Kontaktflächen 12 durchgeführt. Vorliegend wird die bestückte Leiterplatte 10 durch einen Reflow-Ofen geführt.

Vor dem Bestücken der Leiterplatte 10 mit dem Leistungshalbleiter 16 wird die Durchgangsöffnung 22 in das Leiterplattenmaterial 18 im Bereich der vorgegebenen Position eingebracht. Es wird der Wärmeleitkörper 24 bereitgestellt, dessen Abmessungen vorliegend an einen Öffnungsquerschnitt der Durchgangsöffnung 22 angepasst sind. Sodann wird der Wärmeleitkörper 24 in die Durchgangsöffnung 22 eingepresst, sodass der Wärmeleitkörper 24 den Leistungshalbleiter 16 im bestückten Zustand kontaktiert. Anstelle des Einpressens oder ergänzend hierzu kann auch ein Einkleben vorgesehen sein.

Es kann vorgesehen sein, dass der Wärmeleitkörper 24 gemeinsam mit dem Leistungshalbleiter 16 bestückt wird. Zu diesem Zweck kann es erforderlich sein, ein Montagewerkzeug für den Wärmeleitkörper 24 vorzusehen, sodass eine gemeinsame Montage ermöglicht wird.

Besonders vorteilhaft kann jedoch vorgesehen sein, dass der Wärmeleitkörper 24 mittels eines additiven Herstellverfahrens unmittelbar in der Durchgangsöffnung hergestellt wird.

FIG 2 zeigt eine weitere Ausgestaltung für eine Leiterplatte 10 gemäß der Erfindung, die auf der Ausgestaltung gemäß FIG 1 basiert, weshalb ergänzend auf die diesbezüglichen Ausführungen verwiesen wird.

Der Unterschied der Ausgestaltung gemäß FIG 2 gegenüber der Ausgestaltung gemäß FIG 1 besteht darin, dass auf der der Bestückungsseite 26 gegenüberliegenden Leiterplattenseite 28 der Wärmeleitkörper 24 Kühlrippen 30 aufweist. Diese dienen dazu, eine thermische Kopplung mit einem Kühlfluid, welches vorliegend Luft ist, zu verbessern. Die Kühlrippen 30 sind vorzugsweise einstückig mit dem Wärmeleitkörper 24 ausgebildet.

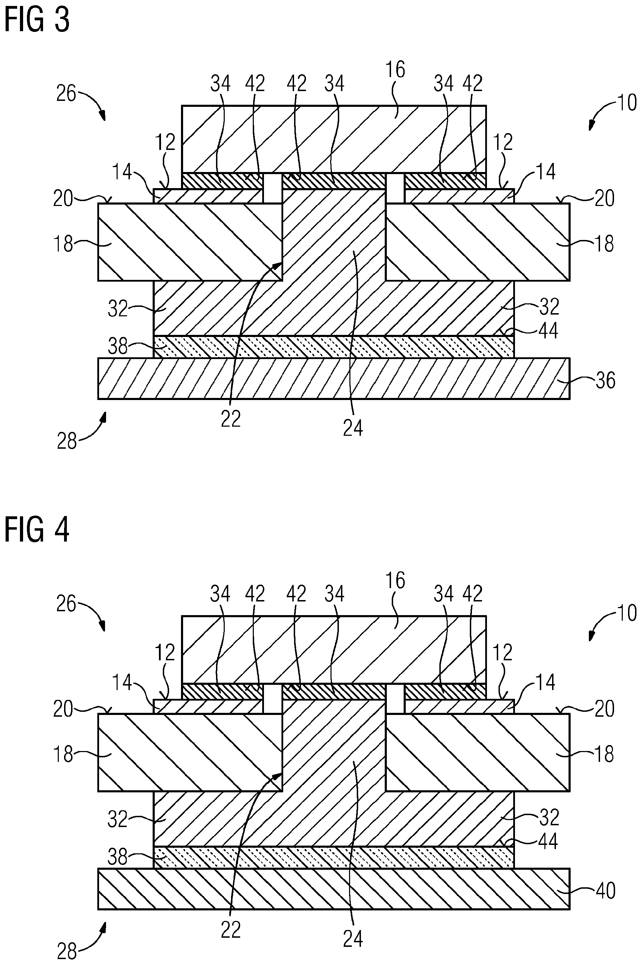

FIG 3 zeigt eine weitere Ausgestaltung für eine Leiterplatte 10 gemäß der Erfindung, die auf der Ausgestaltung gemäß FIG 1 basiert. Deshalb wird auch hier wieder auf die diesbezüglichen Ausführungen zum Ausführungsbeispiel gemäß FIG 1 ergänzend verwiesen.

Im Unterschied zur Ausgestaltung gemäß FIG 1 umfasst die Ausgestaltung gemäß FIG 3 eine Isolierung 38, die an einem dem Leistungshalbleiter 16 gegenüberliegenden Ende 44 des Wärmeleitkörpers 24 ausgebildet ist. Vorliegend ist vorgesehen, dass hier eine Beschichtung aus einem elektrisch isolierenden Werkstoff vorgesehen ist, beispielsweise eine Folie, ein Lack oder dergleichen. Durch die Isolierung 38 kann zum Beispiel ein Berührungsschutz erreicht werden.

An die Isolierung 38 ist eine Heat-Pipe 36 kontaktierend angeordnet, sodass ein Wärmeübergang vom Wärmeleitkörper 24 zur Heat-Pipe 36 ermöglicht ist. Dadurch kann die Kühlwirkung weiter verbessert werden, weil mittels der Heat-Pipe 36 eine erhöhte Wärmeabführung ermöglicht ist.

Durch die Isolierung 38 kann ferner erreicht werden, dass mehrere Wärmeleitkörper, wie der Wärmeleitkörper 24, und/oder auch weitere Leistungshalbleiter, wie der Leitungshalbleiter 16, die Heat-Pipe 36 kontaktieren können, auch wenn sie mit unterschiedlichem elektrischen Potential beaufschlagt sind.

In einer alternativen Ausgestaltung kann die Heat-Pipe 36 auch unmittelbar am Ende 44 angeordnet sein, und zwar wenn die Heat-Pipe 36 gegenüber dem Wärmeleitkörper 24 nicht isoliert zu werden braucht oder anderweitig bereits eine elektrische Isolation vorgesehen ist, beispielsweise zwischen dem Wärmeleitkörper 24 und dem Leistungshalbleiter 16 oder dergleichen.

FIG 4 zeigt eine weitere Ausgestaltung für eine Leiterplatte 10 gemäß der Erfindung, die auf der Ausgestaltung gemäß FIG 3 basiert, weshalb ergänzend auf die diesbezüglichen Ausführungen verwiesen wird.

Gegenüber der Ausgestaltung gemäß FIG 3 ist bei der Ausgestaltung gemäß FIG 4 vorgesehen, dass anstelle der Heat-Pipe 36 ein Wasserkühler 40 vorgesehen ist. Mit dem Wasserkühler 40 kann ebenfalls eine erhöhte Wärmeabführung erreicht werden.

Die Ausführungsbeispiele dienen lediglich der Erläuterung der Erfindung und sind für diese nicht beschränkend. Natürlich können Funktionen, insbesondere auch Ausgestaltungen in Bezug auf Kühlungsmöglichkeiten sowie Ankopplungsmöglichkeiten zum thermischen Abführen von Wärme aus dem Wärmeleitkörper 24, beliebig ausgestaltet sein, ohne den Gedanken der Erfindung zu verlassen. Darüber hinaus kann der Wärmeleitkörper 24 natürlich auch hinsichtlich seiner Struktur, insbesondere im Bereich des Querschnitts, beliebig gestaltet sein, beispielsweise kann er rund, eckig oder dergleichen ausgebildet sein. Vorzugsweise entspricht seine Querschnittstruktur einer Querschnittstruktur der Durchgangsöffnung 22.

Schließlich ist anzumerken, dass die für die erfindungsgemäße Leiterplatte beschriebenen Vorteile und Merkmale sowie Ausführungsformen gleichermaßen für das entsprechende Verfahren gelten und umgekehrt. Folglich können für Vorrichtungsmerkmale entsprechende Verfahrensmerkmale und umgekehrt formuliert sein.

## Patentansprüche

1. Verfahren zum Herstellen einer Leiterplatte (10) mit einer Kühlfunktion für ein in einer vorgegebenen Position auf der Leiterplatte (10) angeordnetes und an Leiterbahnen (14) der Leiterplatte (10) elektrisch angeschlossenes elektronisches Bauteil (16), mit:
- Herstellen der Leiterplatte (10), indem auf einem Leiterplattenmaterial (18) die Leiterbahnen (14) zumindest an einer Oberfläche (20) des Leiterplattenmaterials (18) aufgebracht werden, wobei die Leiterbahnen (14) zumindest elektrische Kontaktflächen (12) zum elektrischen Kontaktieren des wenigstens einen elektronischen Bauteils (16) bereitstellen, und
- Einbringen einer Durchgangsöffnung (22) in die Leiterplatte (10) im Bereich der vorgegebenen Position, **gekennzeichnet durch**
- Hindurchführen eines Wärmeleitkörpers (24) **durch** die Durchgangsöffnung (22) zur Kühlung des elektronischen Bauteils (16).

2. Verfahren nach Anspruch 1,
**dadurch gekennzeichnet, dass**
der Wärmeleitkörper (24) überwiegend Kupfer, Silber, Aluminium oder eine Legierung mit wenigstens einem der vorgenannten Stoffe enthält.

3. Verfahren nach Anspruch 1 oder 2,
**dadurch gekennzeichnet, dass**
vor dem Schritt des Bestückens am Wärmeleitkörper (24) ein Lot (34) angeordnet wird.

4. Verfahren nach einem der vorhergehenden Ansprüche,
**dadurch gekennzeichnet, dass**
der Wärmeleitkörper (24) als Wärmesenke ein Kühlfluid, insbesondere Wasser oder Luft, und/oder eine Heat-Pipe (36) kontaktiert.

5. Verfahren nach einem der vorhergehenden Ansprüche,
**dadurch gekennzeichnet, dass**
der Wärmeleitkörper (24) gemeinsam mit dem wenigstens einen elektronischen Bauteil (16) bestückt wird.

6. Verfahren nach einem der vorhergehenden Ansprüche,
**dadurch gekennzeichnet, dass**
der Wärmeleitkörper (24) mittels eines additiven Herstellverfahrens unmittelbar in der Durchgangsöffnung (22) hergestellt wird.

7. Leiterplatte (10) mit einer Kühlfunktion für wenigstens ein in einer vorgegebenen Position auf der Leiterplatte (10) anordbares und an Leiterbahnen (14) der Leiterplatte (10) elektrisch anschließbares elektronisches Bauteil (16), mit:
- einem Leiterplattenmaterial (18),
- den Leiterbahnen (14), die zumindest an einer Oberfläche (20) des Leiterplattenmaterials (18) angeordnet sind und die zumindest elektrische Kontaktflächen (12) zum elektrischen Kontaktieren des wenigstens einen elektronischen Bauteils (16) aufweisen, und
- einer in die Leiterplatte (10) im Bereich der vorgegebenen Position eingebrachte Durchgangsöffnung (22), **gekennzeichnet durch**
- einen Wärmeleitkörper (24), der **durch** die Durchgangsöffnung (22) zur Kühlung des elektronischen Bauteils (16) hindurchgeführt ist.

8. Leiterplatte nach Anspruch 6,
**dadurch gekennzeichnet, dass**
der Wärmeleitkörper (22), insbesondere einstückig mit dem Wärmeleitkörper (22) ausgebildete, Kühlrippen (30) aufweist.

9. Leiterplatte nach Anspruch 6 oder 7,
**dadurch gekennzeichnet, dass**
der Wärmeleitkörper (22) zumindest in einem Verbindungsbereich mit der Durchgangsöffnung eine elektrische Isolation aufweist.

10. Leiterplatte nach einem der Ansprüche 6 bis 8,
**dadurch gekennzeichnet, dass**
der Wärmeleitkörper (22) auf einer einer Bestückungsseite (26) des wenigstens einen elektronischen Bauteils (16) gegenüberliegenden Leiterplattenseite (28) einen Anschlag (32) aufweist.

11. Leiterplatte nach einem der Ansprüche 6 bis 9,
**dadurch gekennzeichnet, dass**
der Wärmeleitkörper (32) mit wenigstens einer der elektrischen Leiterbahnen elektrisch verbunden ist.
